Europäisches Patentamt

European Patent Office

Office européen des brevets

(19)

(11) **EP 1 110 158 B1**

(12) **EUROPÄISCHE PATENTSCHRIFT**

(45) Veröffentlichungstag und Bekanntmachung des Hinweises auf die Patenterteilung:
**12.02.2003 Patentblatt 2003/07**

(21) Anmeldenummer: **99953654.3**

(22) Anmeldetag: **01.09.1999**

(51) Int Cl.[7]: **G06F 17/50**, G01R 31/28

(86) Internationale Anmeldenummer:
**PCT/DE99/02740**

(87) Internationale Veröffentlichungsnummer:
**WO 00/014660 (16.03.2000 Gazette 2000/11)**

(54) **VERFAHREN UND ANORDNUNG ZUR ÜBERPRÜFUNG EINER STABILITÄT EINES ARBEITSPUNKTES EINER SCHALTUNG**

METHOD AND ARRANGEMENT FOR TESTING THE STABILITY OF A WORKING POINT OF A CIRCUIT

PROCEDE ET SYSTEME POUR VERIFIER LA STABILITE D'UN POINT DE TRAVAIL D'UN CIRCUIT

(84) Benannte Vertragsstaaten:
**DE FR GB**

(30) Priorität: **03.09.1998 DE 19840233**

(43) Veröffentlichungstag der Anmeldung:
**27.06.2001 Patentblatt 2001/26**

(73) Patentinhaber: **Infineon Technologies AG
81669 München (DE)**

(72) Erfinder:
• **NEUBERT, Rolf
D-82008 Unterhaching (DE)**
• **ZHENG, Qinghua
D-82024 Taufkirchen (DE)**

(56) Entgegenhaltungen:
**US-A- 5 483 462**

• **FELDMANN U ET AL: "ALGORITHMS FOR MODERN CIRCUIT SIMULATION" ARCHIV FUR ELEKTRONIK UND UBERTRAGUNGSTECHNIK,DE,S.HIRZEL VERLAG. STUTTGART, Bd. 46, Nr. 4, 1. Juli 1992 (1992-07-01), Seiten 274-285, XP000307557 ISSN: 0001-1096 in der Anmeldung erwähnt**

• **LEVITAS J: "Global stability analysis of fuzzy controllers using cell mapping methods" FUZZY SETS AND SYSTEMS,NL,NORTH-HOLLAND, AMSTERDAM, Bd. 106, Nr. 1, 16. August 1999 (1999-08-16), Seiten 85-97, XP004169206 ISSN: 0165-0114**

• **WIMBROW M U ET AL: "USE NEW SIMULATION FEATURES TO IMPROVE YOUR ANALOG DESIGNS" EDN ELECTRICAL DESIGN NEWS,US,CAHNERS PUBLISHING CO. NEWTON, MASSACHUSETTS, Bd. 36, Nr. 11, 23. Mai 1991 (1991-05-23), Seiten 151-158,160, XP000231143 ISSN: 0012-7515**

• **MATHIS W ET AL: "FINDING ALL DC EQUILIBRIUM POINTS OF NONLINEAR CIRCUITS" PROCEEDINGS OF THE MIDWEST SYMPOSIUM ON CIRCUITS AND SYSTEMS,US,NEW YORK, IEEE, Bd. SYMP. 32, 1989, Seiten 462-465, XP000139693**

• **NICHOLS K G ET AL: "OVERVIEW OF SPICE-LIKE CIRCUIT SIMULATION ALGORITHMS" IEE PROCEEDINGS: CIRCUITS DEVICES AND SYSTEMS,GB,INSTITUTION OF ELECTRICAL ENGINEERS, STENVENAGE, Bd. 141, Nr. 4, 1. August 1994 (1994-08-01), Seiten 242-250, XP000473245 ISSN: 1350-2409**

**Beschreibung**

Die Erfindung betrifft ein Verfahren und eine Anordnung zur Überprüfung einer Stabilität eines Arbeitspunktes einer Schaltung.

Eine Schaltung, insbesondere eine analoge elektrische Schaltung (Analogschaltung), enthält häufig inhärent Instabilitäten (auch: instabile Arbeitspunkte, instabile Punkte), die gezielt ausgenutzt werden, um vorgegebenen Anforderungen zu entsprechen.

Ein Beispiel ist ein Stromvergleicher, der eine Referenzstromstärke mit einer Eingangsstromstärke vergleicht und abhängig von der Differenz zwischen beiden Stromstärken, eine Ausgangsspannung auf jeweils einen von zwei möglichen Werten setzt. Bei diesem Stromvergleicher gibt es zwei stabile Außenlagen und eine instabile Mittellage. Der Stromvergleicher basiert auf einem sogenannten "Flip-Flop-Prinzip".

Nun ist es generell von großem Interesse, die Stabilität einzelner Arbeitspunkte der Schaltung zu ermitteln. Dazu ist es üblich, eine Systemantwort auf einzelne, lokale Konfigurationen zu erzeugen und auszuwerten (siehe [3]). Dabei erhält man lediglich eine lokale Sicht auf die Dynamik der Schaltung, eine Auswertung abhängig von der Zeit t ist extrem rechenintensiv.

Ein Fortsetzungsverfahren zur Bestimmung einer DC-Transferkurve für eine Schaltung ist aus [1] bekannt.

Mit einem Eigenwertverfahren nach [2] wird für einen Arbeitspunkt einer Schaltung bestimmt, ob es sich jeweils um einen asymptotisch stabilen Punkt (Attraktor) oder einen instabilen Punkt handelt.

Die **Aufgabe** der Erfindung besteht darin, ein Verfahren und eine Anordnung anzugeben, das bzw. die eine direkte Berechnung einer globalen Dynamik für eine Schaltung erlaubt.

Diese Aufgabe wird gemäß den Merkmalen der unabhängigen Patentansprüche gelöst. Weiterbildungen ergeben sich auch aus den abhängigen Ansprüchen.

Zur Lösung der Aufgabe wird ein Verfahren zur Ermittlung einer globalen Dynamik einer Schaltung angegeben, bei dem eine DC-Transferkurve der Schaltung ermittelt wird. Für Punkte der DC-Transferkurve wird eine Stabilitätsanalyse durchgeführt, wobei für Punkte der DC-Transferkurve bestimmt wird, ob diese jeweils asymptotisch stabil sind oder nicht. Weiterhin werden mindestens ein stabiler Bereich der DC-Transferkurve und mindestens ein instabiler Bereich der DC-Transferkurve bestimmt, wobei jeder Bereich eine Reihe von zusammenhängenden stabilen bzw. instabilen Punkten enthält. Die Dynamik der Schaltung ist somit bestimmt durch den mindestens einen stabilen Bereich und den mindestens einen instabilen Bereich.

Mit zusammenhängenden Punkten sind Punkte der gleichen Zuordnung "stabil" bzw. "instabil" gemeint.

Mit erfolgreicher Bestimmung der (globalen) Dynamik der Schaltung ist es möglich, eine Robustheit der Schaltung für einzelne Punkte (auch: Arbeitspunkte), die nicht auf der DC-Transferkurve liegen, zu ermitteln. In einer Weiterbildung erfolgt die Bestimmung eines Arbeitspunkts, indem der Arbeitspunkt dem nächstliegenden stabilen Bereich der DC-Transferkurve zugeordnet wird.

Eine andere Weiterbildung besteht darin, daß die DC-Transferkurve mittels Fortsetzungsverfahren [1] bestimmt wird.

Die DC-Transferkurve enthält einen stationären Zustand oder mehrere stationäre Zustände in Abhängigkeit von einer Wertebelegung eines Parameters. Für ein dynamisches System

$$G\left(\underline{\dot{v}}, \underline{v}, \lambda\right) = \underline{0} \qquad\qquad (1)$$

werden stationäre Lösungen ermittelt, indem das Gleichungssystem

$$f\left(\underline{v}, \lambda\right) := G\left(\underline{0}, \underline{v}, \lambda\right) = \underline{0} \qquad \left(\underline{\dot{v}} = \underline{0}\right) \qquad\qquad (2)$$

gelöst wird, wobei

$\underline{\dot{v}}$      eine dynamische Veränderung eines Zustandsvektors,

$\underline{v}$      einen Zustandsvektor und

$\lambda$      einen Parameter

der Schaltung bezeichnen. Ein solches Gleichungssystem (2) kann mittels Standardverfahren, z.B. Newtonverfahren (siehe [3]), gelöst werden.

Das Fortsetzungsverfahren ermöglicht die Bestimmung eines nächsten Punktes auf der DC-Transferkurve, indem in einer Richtung entlang eines vermuteten Verlaufs der DC-Transferkurve ein nächster Punkt geschätzt wird und dieser Punkt als Startwert für Gleichung (2) dient. Nach mehreren Iterationsschritten ergibt sich der richtige nächste Punkt, der tatsächlich (zumindest innerhalb einer vorgegebenen Näherung) auf der DC-Transferkurve liegt.

Im Rahmen der Stabilitätsanalyse werden die Punkte der DC-Transferkurve auf deren Stabilität hin untersucht. Insbesondere mit dem Eigenwertverfahren (siehe [2]) wird vorzugsweise für jeden Punkt oder eine vorgegebene Anzahl von Punkten auf der DC-Transferkurve überprüft, ob dieser jeweils asymptotisch stabil ist. Ein solcher Punkt ist ein Attraktor. Der Attraktor ist dadurch bestimmt, daß hinsichtlich der Stabilität innerhalb einer kleinen Umgebung um diesen alle Punkte auf ihn zulaufen. Der Attraktor stellt somit ein stabiles Zentrum für seine unmittelbare Umgebung dar.

Aus dem Ergebnis der Stabilitätsanalyse kann, insbesondere bei Vergleicherschaltungen, eine Trennung der stabilen Außenlagen durch die instabile Mittellage erfolgen.

Es ist dabei von Vorteil, daß bei der beschriebenen Ermittlung der globalen Dynamik die zeitlichen Abhängigkeiten der Schaltung unberücksichtigt bleiben können.

Bisher wurde, ausgehend von vielen einzelnen lokalen Ausgangskonfigurationen, eine Integration (Transientenanalyse) durchgeführt. Das Ergebnis wird mittels Expertenwissens interpretiert, um auf die gesuchte globale Dynamik der Schaltung rückschließen zu können. Für eine Transientenanalyse (für nur einen Ausgangspunkt) kann mit einem Zeitaufwand von bis zu 30 Minuten gerechnet werden, wohingegen die Bestimmung der globalen Dynamik (ohne Expertenwissen) mit dem hier vorgestellten Verfahren in 10 Minuten möglich ist. Somit ist es auch möglich, das Verfahren als Vorverarbeitungsschritt einzusetzen, an den sich ggf. eine Transientenanalyse für einzelne Punkte, die von besonderem Interesse sind, anschließt.

Im Rahmen einer zusätzlichen Weiterbildung kann der instabile Bereich eine Prozeßtoleranz ($\Delta T$) aufweisen, die direkt proportional zu einer Sensitivität ($\Delta s$) und indirekt proportional zu einer Geschwindigkeit der Schaltung ist.

Bei einem Entwurf oder einer Auslegung einer (elektrischen) Schaltung ist es von Vorteil, alle konkurrierenden Größen auf einmal darstellen zu können. Derartig konkurrierende Größen sind die Geschwindigkeit der Schaltung, die Sensitivität (Empfindlichkeit) und die (herstellungsbedingte) Prozeßtoleranz der Schaltung. In einer Designphase der Schaltung ist es maßgebend für eine durch einen jeweiligen Anwendungsfall bestimmte Vorgabe, bestimmte Werte für bestimmte Zielgrößen zu erfüllen. Beispielsweise sind die Geschwindigkeit und die Sensitivität der Schaltung konkurrierende Ziele, zwischen beiden ist eine Kompromißlösung zu bestimmen.

Eine Ausgestaltung besteht darin, daß das beschriebene Verfahren zum Entwurf einer Vergleicherschaltung, insbesondere einer Stromvergleicherschaltung eingesetzt wird.

Eine andere Ausgestaltung besteht in der Verwendung zum Entwurf einer Speicherschaltung.

Allgemein eignet sich der Einsatz des beschriebenen Verfahrens insbesondere zum Entwurf von Schaltungen, bei denen mindestens eine Instabilität ausgenutzt wird, um eine Funktionalität zu erzielen.

Beim Stromvergleicher wird die Instabilität ausgenutzt, um mit einem geringen Strom einen großen Ausgangswert (vorzugsweise eine Spannung) zu steuern.

Auch wird zur Lösung oben genannter Aufgabe eine Anordnung zur Überprüfung einer Stabilität eines Arbeitspunktes einer Schaltung angeben, die eine Prozessoreinheit aufweist, welche Prozessoreinheit derart eingerichtet ist, daß

a) eine DC-Transferkurve der Schaltung ermittelbar ist;

b) für Punkte der DC-Transferkurve eine Stabilitätsanalyse durchführbar ist, wobei für jeden Punkt ermittelt wird, ob dieser ein asymptotisch stabiler Punkt ist oder nicht;

c) ein stabiler Bereich der DC-Transferkurve die asymptotisch stabilen Punkte und ein instabiler Bereich der DC-Transferkurve die instabilen Punkte enthält;

d) die globale Dynamik der Schaltung durch den mindestens einen stabilen Bereich und den mindestens einen instabilen Bereich gekennzeichnet ist.

Diese Anordnung ist insbesondere geeignet zur Durchführung des erfindungsgemäßen Verfahrens oder einer seiner vorstehend erläuterten Weiterbildungen.

Ausführungsbeispiele der Erfindung werden nachfolgend anhand der Zeichnung dargestellt und erläutert.

Es zeigen

Fig.1    Ein- und Ausgangsgrößen eines Stromvergleichers;

Fig.2 ein Kurvenverlauf, der eine globale Dynamik einer Schaltung darstellt;

Fig.3 einen Kurvenverlauf der einen Ausschnitt aus Fig.2 darstellt;

Fig.4 ein Beispiel für einen Punkt, der nicht asymptotisch stabil ist;

Fig.5 ein Beispiel für einen Attraktor;

Fig.6 ein Blockdiagramm, das Schritte zur Bestimmung der globalen Dynamik einer Schaltung und Verwendungsmöglichkeiten dieser globalen Dynamik darstellt;

Fig.7 eine Prozessoreinheit.

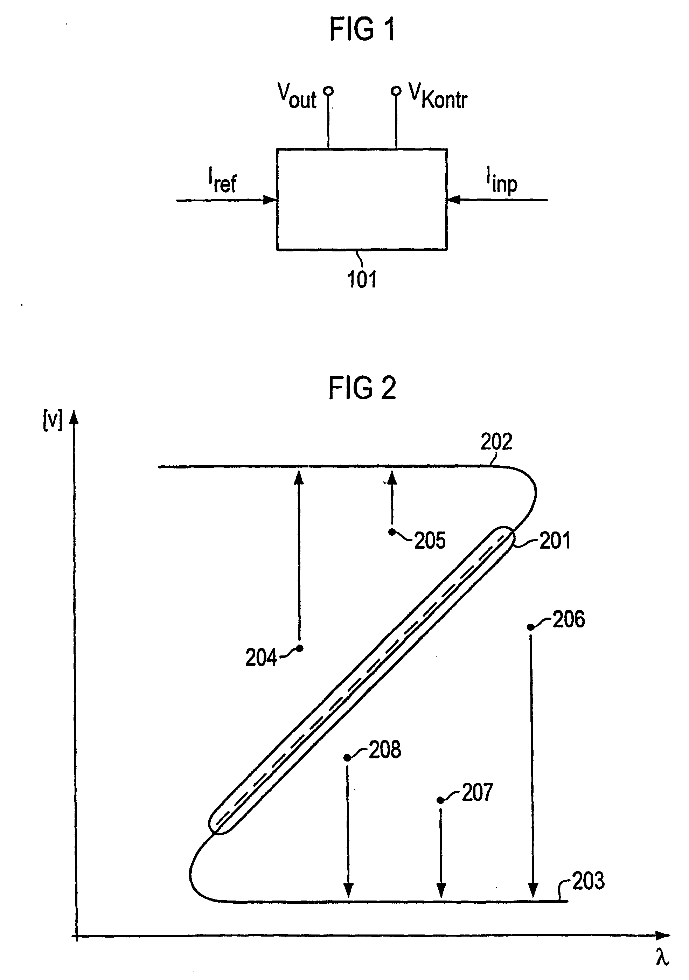

**Fig.1** stellt schematisch einen Stromvergleicher 101 dar, der einen Referenzstrom $I_{ref}$ mit einem Eingangs- strom $I_{inp}$ vergleicht und das Ergebnis des Vergleichs in Form einer Ausgangsspannung $v_{out}$ angibt. Für eine Einstellung des Stromvergleichers ist eine Kontrollspannung $v_{kontr}$ vorgesehen.

Das Funktionsprinzip des Stromvergleichers ist in **Fig.2** dargestellt. Der Stromvergleicher 101 basiert auf einem sogenannten Flip-Flop-Prinzip, d.h. außerhalb einer instabilen Mittellage 201 gibt es je eine stabile Außenlage 202 und 203, auf die sich die Ausgangsspannung $v_{out}$, angezeichnet an der Ordinate, einstellt. Theoretisch könnte vout auch in der instabilen Mittellage 201 verbleiben, dies ist jedoch bei einem realen technischen System beliebig unwahrscheinlich. Weiterhin wäre dann für Arbeitspunkte auf der instabilen Mittellage 201 keine Vorhersage einer stabilen Außenlage 202 oder 203 möglich.

Die Schaltung wird mittels der Kontrollspannung $v_{kontr}$ in die Nähe der instabilen Mittellage eingestellt ($v_{kontr}$ auf "arbeitsbereit"). Durch den Vergleich zweier Stromstärken $I_{ref}$ und $I_{inp}$ erfolgt eine Auslenkung der Ausgangsspan- nung $v_{out}$ nach oben oder nach unten in eine stabile Außenlage 202 oder 203. Diese Auslenkung ist begründet in der nichtlinearen Dynamik der Schaltung, die sehr schnell und äußerst sensitiv in eine der beiden Außenlagen 202 oder 203 übergeht.

Somit folgt durch Vorgabe eines Parameters $\lambda$ (vergleiche Fig.2) die Vorgabe eines Arbeitspunktes (z.B. einer der eingezeichneten Punkte 204 bis 208), wobei die nichtlineare Dynamik der Schaltung (dargestellt durch den Kurvenverlauf 202, 201 und 203) den Arbeitspunkt in seine nächstliegende stabile Außenlage überführt. Es ist somit möglich, voherzusagen, in welche stabile Außenlage 202 oder 203 der jeweilige Arbeitspunkt übergeht. Im Beispiel von Fig.2 werden die Arbeitspunkte 204 und 205 in die stabile Außenlage 202 überführt, die Arbeitspunkte 206, 207 und 208 werden in die stabile Außenlage 203 überführt.

Im Beispiel des oben beschriebenen Stromvergleichers stellt der Parameter $\lambda$ eine Differenz $I_{inp}$-$I_{ref}$ der zu vergleichenden Stromstärke $I_{inp}$ und der Referenzstromstärke $I_{ref}$ dar.

Hierbei sei darauf hingewiesen, daß der Parameter $\lambda$ einen zusätzlichen Freiheitsgrad gegenüber einem Lösungsvektor [v] darstellt. In der Regel weist dieser Lösungsvektor [v] eine Dimension n auf, mit dem Parameter $\lambda$ ergibt sich somit die Dimension zu n+1. Zum Zwecke der Darstellbarkeit kann der Lösungsvektor [v] auf eine eindimensionale Darstellung reduziert werden, z.B. durch Bildung eines euklidischen Abstands seiner Komponenten.

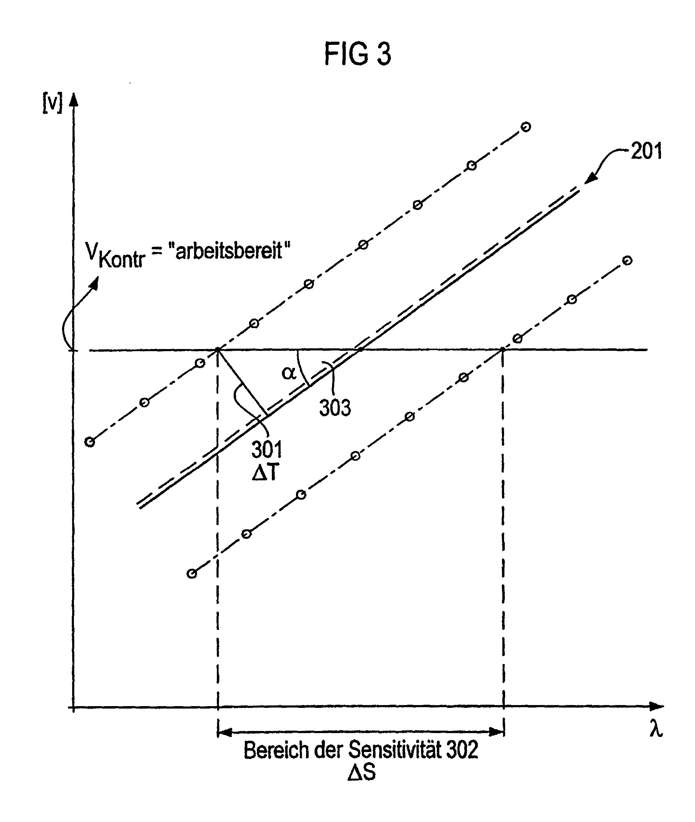

**Fig.3** zeigt einen Ausschnitt des Kurvenverlaufs 201 aus Fig.2. Reale Schaltungen weisen im Bereich ihrer instabilen Mittellage 201 eine gewisse "Unschärfe" auf, die hier als eine Prozeßtoleranz 301 bezeichnet wird. Diese Prozeßtoleranz 301 ergibt sich aus der Herstellung der Schaltung (Fabrikationstoleranz). Insbesondere physikalische Abmessungen fließen in diese Prozeßtoleranz 301 ein. Die Kontrollspannung $v_{kontr}$ gibt eine Sensitivität 302 der Schaltung vor. Diese Sensitivität 302 ist bestimmt durch die auf die Abszisse projizierten Schnittpunkte der Grenzen der Prozeßtoleranz 301 mit der Kontrollspannung $v_{kontr}$. Eine weitere wichtige Größe stellt die Geschwindigkeit der Schaltung dar, für die der Winkel $\alpha$ 303 zwischen der instabilen Mittellage 201 und der Kontrollspannung $v_{kontr}$ ein Maß ist (kleinere Winkel $\alpha$ korrespondieren mit höherer Geschwindigkeit).

Es ergibt sich also insbesondere die Beziehung

$$\Delta s \propto \frac{\Delta T}{\sin \alpha},$$

mit folgenden Implikationen:

a) Für eine vorgegebene Geschwindigkeit (Winkel $\alpha$ = konstant) gilt: Je größer die Prozeßtoleranz $\Delta T$, desto kleiner die Sensitivität (desto größer der Bereich $\Delta s$ der Sensitivität auf der Abszisse in Figur 3).

b) Für eine vorgegebene Prozeßtoleranz $\Delta T$ (=konstant) gilt: Je größer die Geschwindigkeit der Schaltung (je kleiner der Winkel α), desto kleiner die Sensitivität (desto größer der Bereich Δs).

c) Für eine vorgegebene Sensitivität (Δs=konstant) gilt: Je größer die Prozeßtoleranz ΔT, desto kleiner ist die Geschwindigkeit der Schaltung (desto größer ist der Winkel α).

Es ergeben sich also mehrere miteinander konkurrierende Ziele, die im Rahmen eines Schaltungsentwurfs (Design einer Schaltung) gegeneinander abzuwägen sind. Besonderen Vorgaben wird entsprochen, indem eine Prozeßtoleranz 301 geeignet gewählt wird. Dies ist für jeden Anwendungsfall vom zuständigen Designfachmann individuell abzuklären.

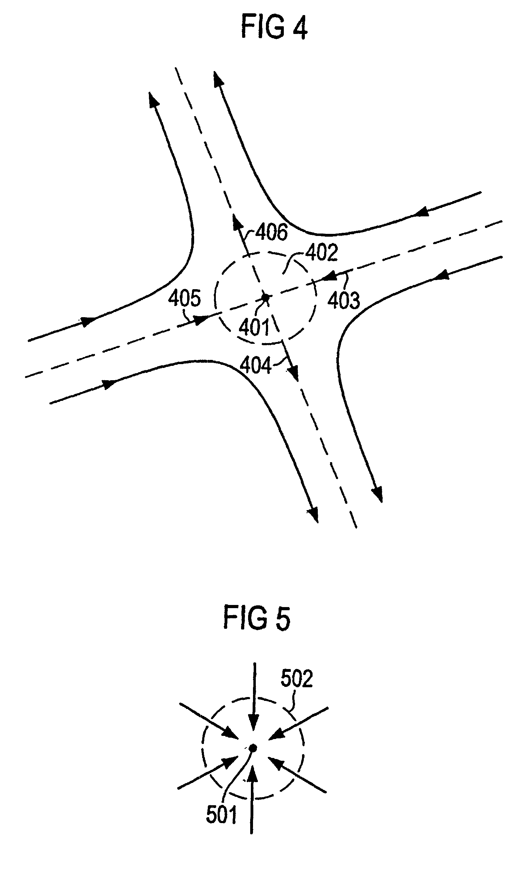

In Fig.2 ist der Kurvenverlauf der globalen Dynamik einer zugrundeliegenden Schaltung dargestellt, wobei insbesondere für jeden Punkt auf dieser Kurve unterschieden wird, ob dies jeweils ein asymptotisch stabiler Punkt (siehe Kurvenabschnitte 202 und 203) oder ein instabiler Punkt ist (instabile Mittellage 201). In **Fig.4** ist ein Beispiel für einen nicht asymptotisch stabilen Punkt 401 dargestellt. In einer unmittelbaren Umgebung 402 dieses Punktes 401 gibt es Punkte, die auf diesen Punkt 401 zulaufen, z.B. die Punkte auf den Achsenabschnitten 403 und 405. Allerdings gibt es auch Punkte, nämlich auf den Achsenabschnitten 404 und 406, die von dem Punkt 401 weglaufen. Somit ist der Punkt 401 nicht asymptotisch stabil. Hingegen zeigt **Fig.5** einen Punkt 501, in dessen unmittelbarer Umgebung 502 alle Punkte zu diesem Punkt hin verlaufen. Punkt 501 ist daher ein Attraktor.

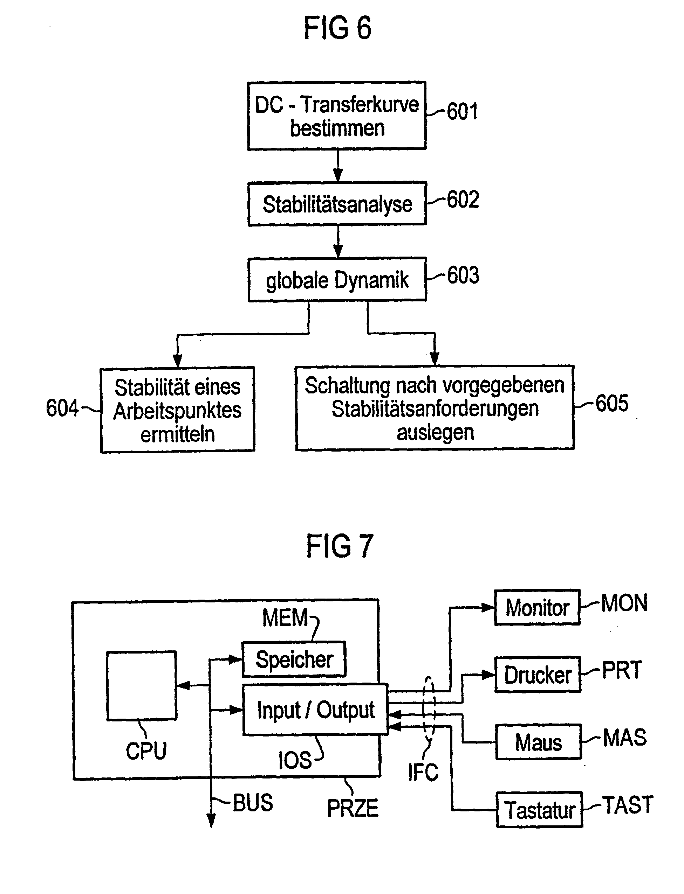

**Fig.6** zeigt ein Blockdiagramm mit Schritten zur Bestimmung der globalen Dynamik einer Schaltung und mit Verwendungsmöglichkeiten dieser globalen Dynamik. In einem Schritt 601 wird die DC-Transferkurve mittels eines Fortsetzungsverfahrens (siehe [1]) bestimmt. Jeder Punkt oder eine vorgegebene Menge von Punkten auf der DC-Transferkurve werden einer Stabilitätsanalyse (siehe [2]) unterzogen (siehe Schritt 602), so daß für diese Punkte bestimmt ist, ob es sich jeweils um einen Attraktor handelt oder nicht. Zusammenhängende Attraktoren stellen eine stabile Außenlage und zusammenhängende Punkte, die keine Attraktoren sind, stellen die instabile Mittellage dar. Somit ergibt sich ein Kurvenverlauf, der stabile Außenlagen und eine instabile Mittellage umfaßt und die globale Dynamik der zugrundeliegenden Schaltung kennzeichnet (siehe Schritt 603). Arbeitspunkte, die nicht exakt auf der instabilen Mittellage liegen, werden als einen stabilen Endzustand die nächstgelegene stabile Außenlage einnehmen. Auf diese Art ist die Bestimmung der Stabilität eines Arbeitspunktes (Schritt 604) möglich. Weiterhin wird alternativ ein Schaltungsentwurf gemäß den Aussagen der globalen Dynamik der Schaltung geeignet angepaßt, so daß bestimmten Vorgaben entsprochen wird.

In **Fig.7** ist eine Prozessoreinheit PRZE dargestellt. Die Prozessoreinheit PRZE umfaßt einen Prozessor CPU, einen Speicher SPE und eine Input/Output-Schnittstelle IOS, die über ein Interface IFC auf unterschiedliche Art und Weise genutzt wird: Über eine Grafikschnittstelle wird eine Ausgabe auf einem Monitor MON sichtbar und/oder auf einem Drucker PRT ausgegeben. Eine Eingabe erfolgt über eine Maus MAS oder eine Tastatur TAST. Auch verfügt die Prozessoreinheit PRZE über einen Datenbus BUS, der die Verbindung von einem Speicher MEM, dem Prozessor CPU und der Input/Output-Schnittstelle IOS gewährleistet. Weiterhin sind an den Datenbus BUS zusätzliche Komponenten anschließbar, z.B. zusätzlicher Speicher, Datenspeicher (Festplatte) oder Scanner.

Literaturverzeichnis:

[1] U.Feldmann et al.: "Algorithms for Modern Circuit Simulation", AEÜ, Vol.46(1992, No.4, Hirzel-Verlag Stuttgart, Seiten 274-285.

[2] R.Neubert: "An Effective Method for the Stability Analysis of Steady States in the Simulation of Large Electrical Networks", In: W.Mathis & P.Noll (eds.), 2.ITG-Diskussionssitzung: Neue Anwendungen theoretischer Konzepte in der Elektrotechnik, Seiten 41-48, Berlin, (4)1995, ITG, VDE-Verlag.

[3] L.O.Chua et al.: "Computer-Aided Analysis of Electronic Circuits: Algorithms and Computational Techniques", Prentice Hall, 1975.

**Patentansprüche**

1.   Verfahren zur Ermittlung einer globalen Dynamik einer Schaltung,

a) bei dem eine DC-Transferkurve (601) der Schaltung ermittelt wird;

b) bei dem für Punkte der DC-Transferkurve eine Stabilitätsanalyse (602) durchgeführt wird, wobei für jeden Punkt ermittelt wird, ob dieser ein asymptotisch stabiler Punkt ist oder nicht;

c) bei dem ein stabiler Bereich der DC-Transferkurve die asymptotisch stabilen Punkte (202,203) und ein instabiler Bereich der DC-Transferkurve die instabilen Punkte (201) enthält;

d) bei dem die globale Dynamik (603) der Schaltung durch den mindestens einen stabilen Bereich und den mindestens einen instabilen Bereich gekennzeichnet ist.

**2.** Verfahren nach Anspruch 1,
bei dem eine Überprüfung einer Stabilität eines Arbeitspunktes erfolgt, indem der Arbeitspunkt dem nächstliegenden stabilen Bereich der DC-Transferkurve zugeordnet wird.

**3.** Verfahren nach Anspruch 1 oder 2,
bei dem die DC-Transferkurve mittels eines Fortsetzungsverfahren bestimmt wird.

**4.** Verfahren nach einem der vorhergehenden Ansprüche,
bei dem die Stabilitatsanalyse mit einem Eigenwertverfahren durchgeführt wird.

**5.** Verfahren nach einem der vorhergehenden Ansprüche,
bei dem der instabile Bereich eine Prozesstoleranz aufweist, die direkt proportional zu einer Sensitivität und indirekt proportional zu einer Geschwindigkeit der Schaltung ist.

**6.** Verfahren nach Anspruch 5,
bei dem die Größen Sensitivität, Geschwindigkeit und Prozesstoleranz einer Schaltung bestimmt werden.

**7.** Verfahren zum Entwurf einer Schaltung nach einem der Ansprüche 1 bis 6,
bei dem eine oder mehrere der Größen Sensitivität, Geschwindigkeit und Prozesstoleranz vorgegeben sind und die jeweils verbleibende Größe bzw. die jeweils verbleibenden Größen anhand der vorgegebenen Größen dimensioniert werden.

**8.** Verfahren nach einem der Ansprüche 1 bis 7
zum Entwurf einer Vergleicherschaltung, insbesondere einer Stromvergleicherschaltung.

**9.** Verfahren nach einem der Ansprüche 1 bis 7
zum Entwurf einer Speicherschaltung.

**10.** Verfahren nach einem der Ansprüche 1 bis 7
zum Entwurf von Schaltungen, bei denen mindestens eine Instabilität ausgenutzt wird, um eine Funktionalität zu erzielen.

**11.** Anordnung zur Überprüfung einer Stabilität eines Arbeitspunktes einer Schaltung
mit einer Prozessoreinheit, die derart eingerichtet ist, daß

a) eine DC-Transferkurve (601) der Schaltung ermittelbar ist;

b) für Punkte der DC-Transferkurve eine Stabilitätsanalyse (602) durchführbar ist, wobei für jeden Punkt ermittelt wird, ob dieser ein asymptotisch stabiler Punkt ist oder nicht;

c) ein stabiler Bereich der DC-Transferkurve die asymptotisch stabilen Punkte (202,203) und ein instabiler Bereich der DC-Transferkurve die instabilen Punkte (201) enthält;

d) die globale Dynamik (603) der Schaltung durch den mindestens einen stabilen Bereich und den mindestens einen instabilen Bereich gekennzeichnet ist.

**Claims**

1. Method for determining the global dynamics of a circuit,

   a) in which a DC transfer curve (601) of the circuit is determined;

   b) in which a stability analysis (602) is carried out for points on the DC transfer curve, with the determination being made for each point as to whether or not this point corresponds to a asymptotically stable point;

   c) in which a stable region of the DC transfer curve contains the asymptotically stable points (202, 203) and an unstable region of the DC transfer curve contains the unstable points (201);

   d) in which the global dynamics (603) of the circuit are **characterized by** the at least one stable region and the at least one unstable region.

2. Method according to Claim 1, in which the stability of an operating point is checked by associating the operating point with the closest stable region of the DC transfer curve.

3. Method according to Claim 1 or 2, in which the DC transfer curve is determined by means of a continuation method.

4. Method according to one of the preceding claims, in which the stability analysis is carried out using an eigen value method.

5. Method according to one of the preceding claims, in which the unstable region has a process tolerance which is directly proportional to a sensitivity and is indirectly proportional to a rate of the circuit.

6. Method according to Claim 5,
   in which the sensitivity, rate and process tolerance of a circuit are determined as the variables.

7. Method for designing a circuit according to one of Claims 1 to 6,
   in which one or more of the sensitivity, rate and process tolerance are predetermined as the variables, and the respectively remaining variable or the respectively remaining variables are dimensioned on the basis of the predetermined variables.

8. Method according to one of Claims 1 to 7,
   for designing a comparator circuit, in particular a current comparator circuit.

9. Method according to one of Claims 1 to 7,
   for designing a storage circuit.

10. Method according to one of Claims 1 to 7,
    for designing circuits in which at least one instability is used in order to achieve a functionality.

11. Arrangement for checking the stability of an operating point of a circuit,
    having a processor unit which is set up such that:

    a) a DC transfer curve (601) of the circuit can be determined;

    b) a stability analysis (602) can be carried out for points on the DC transfer curve, with the determination being made for each point as to whether or not this point corresponds to a asymptotically stable point;

    c) a stable region of the DC transfer curve contains the asymptotically stable points (202, 203) and an unstable region of the DC transfer curve contains the unstable points (201);

    d) the global dynamics (603) of the circuit are **characterized by** the at least one stable region and the at least one unstable region.

**Revendications**

1. Procédé de détermination de la dynamique globale d'un circuit,

   a) dans lequel on détermine une courbe de transfert DC (601) du circuit;
   b) dans lequel on exécute une analyse de stabilité (602) pour des points de la courbe de transfert CC, dans laquelle pour chaque point, on détermine s'il s'agit d'un point est un point asymptotiquement stable ou non;
   c) dans lequel une plage stable de la courbe de transfert CC contient les points asymptotiquement stables (202, 203) et une plage instable de la courbe de transfert CC contient les points instables (201);
   d) dans lequel la dynamique globale (603) du circuit est **caractérisée par** l'au moins une plage stable, et par l'au moins une plage instable.

2. Procédé selon la revendication 1, dans lequel on vérife la stabilité d'un point de travail en associant le point de travail à la plage stable la plus proche de la courbe de transfert CC.

3. Procédé selon la revendication 1 ou 2, dans lequel la courbe de transfert CC est déterminée au moyen d'un procédé de continuation.

4. Procédé selon l'une des revendications précédentes, dans lequel l'analyse de stabilité est réalisée avec un procédé à valeurs propres.

5. Procédé selon l'une des revendications précédentes, dans lequel la zone instable présente une tolérance de processus qui est directement proportionnelle à une sensibilité et indirectement proportionnelle à une vitesse du circuit.

6. Procédé selon la revendication 5, dans lequel les grandeurs sensibilité, vitesse et tolérance de processus d'un circuit sont déterminées.

7. Procédé de développement d'un circuit selon l'une des revendications 1 à 6, dans lequel une ou plusieurs des grandeurs sensibilité, vitesse et tolérance de processus sont prédéterminées, et la resp. les grandeurs restantes sont dimensionnées à l'aide de la resp. les grandeurs prédéterminées.

8. Procédé selon l'une des revendications 1 à 7 pour le développement d'un circuit comparateur, en particulier un circuit comparateur de courant.

9. Procédé selon l'une des revendications 1 à 7 pour le développement d'un circuit de mémoire.

10. Procédé selon l'une des revendications 1 à 7 pour le développement de circuits dans lesquels on utilise au moins une instabilité pour créer une fonctionnalité.

11. Agencement de vérification de la stabilité d'un point de travail d'un circuit à l'aide d'une unité de processeur qui est équipée de telle sorts que:

   a) on peut déterminer une courbe de transfert CC (601) du circuit;
   b) pour des points de la courbe de transfert CC, on peut réaliser une analyse de stabilité (602), dans laquelle pour chaque point, on détermine s'il s'agit d'un point asymptotiquement stable ou non;
   c) une plage stable de la courbe de transfert CC contient les points asymptotiquement stables (202, 203) et une plage instable de la courbe de transfert CC contient les points instables (201);
   d) la dynamique globale (603) du circuit est **caractérisée par** l'au moins une plage stable, et l'au moins une plage instable.

# FIG 1

$V_{out}$ ○   ○ $V_{Kontr}$

$I_{ref}$ →   ← $I_{inp}$

101

# FIG 2

[v]

202
205
201
204
206
208
207
203

λ

# FIG 3

$V_{Kontr}$ = "arbeitsbereit"

201

α

303

301
ΔT

Bereich der Sensitivität 302
ΔS

[V]

λ

## FIG 4

## FIG 5

## FIG 6

```
DC - Transferkurve
bestimmen          601

        ↓

Stabilitätsanalyse   602

        ↓

globale Dynamik      603
```

604 — Stabilität eines Arbeitspunktes ermitteln

Schaltung nach vorgegebenen Stabilitätsanforderungen auslegen — 605

## FIG 7

```
        MEM
      ┌────────┐
      │Speicher│
      └────────┘
┌──────┐
│ CPU  │
└──────┘
    ┌────────────┐
    │Input / Output│
    └────────────┘
        IOS
   BUS      PRZE
```

Monitor — MON

Drucker — PRT

Maus — MAS

Tastatur — TAST

IFC